(19) **Europäisches Patentamt / European Patent Office / Office européen des brevets**

(11) **EP 2 713 172 B1**

(12) # EUROPEAN PATENT SPECIFICATION

(45) Date of publication and mention
of the grant of the patent:
**29.05.2019 Bulletin 2019/22**

(51) Int Cl.:
***G01R 19/25*** *(2006.01)*

(21) Application number: **12186082.9**

(22) Date of filing: **26.09.2012**

(54) **Measurement apparatus for electricity distribution grids**

Messvorrichtung für Stromverteilungsnetze

Appareil de mesure pour réseaux de distribution d'électricité

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**02.04.2014 Bulletin 2014/14**

(73) Proprietor: **Rheinisch-Westfälisch-Technische Hochschule Aachen
52062 Aachen (DE)**

(72) Inventors:
• **Monti, Antonello
52072 Aachen (DE)**
• **Liu, Junqi
76149 Karlsruhe (DE)**
• **Ni, Fei
201800 Shanghai (CN)**
• **Muscas, Carlo
09131 Cagliari (IT)**
• **Pegoraro, Paolo Attilio
09127 Cagliari (IT)**
• **Castello, Paolo
09126 Cagliari (IT)**

(74) Representative: **dompatent von Kreisler Selting Werner -
Partnerschaft von Patent- und Rechtsanwälten mbB
Deichmannhaus am Dom
Bahnhofsvorplatz 1
50667 Köln (DE)**

(56) References cited:
**US-A1- 2006 247 874    US-A1- 2009 099 798**

• **DE LA O SERNA J A ET AL: "Taylor Kalman Fourier Filters for Instantaneous Oscillating Phasor and Harmonic Estimates", IEEE TRANSACTIONS ON INSTRUMENTATION AND MEASUREMENT, IEEE SERVICE CENTER, PISCATAWAY, NJ, US, vol. 61, no. 4, 1 April 2012 (2012-04-01), pages 941-951, XP011454423, ISSN: 0018-9456, DOI: 10.1109/TIM.2011.2178677**
• **PAOLO CASTELLO ET AL: "Performance comparison of algorithms for synchrophasors measurements under dynamic conditions", APPLIED MEASUREMENTS FOR POWER SYSTEMS (AMPS), 2011 IEEE INTERNATIONAL WORKSHOP ON, IEEE, 28 September 2011 (2011-09-28), pages 25-30, XP032028528, DOI: 10.1109/AMPS.2011.6090351 ISBN: 978-1-61284-946-1**
• **JUNJIE TANG ET AL: "Impact of PMU sychronization on wide area state estimation", APPLIED MEASUREMENTS FOR POWER SYSTEMS (AMPS), 2011 IEEE INTERNATIONAL WORKSHOP ON, IEEE, 28 September 2011 (2011-09-28), pages 74-79, XP032028530, DOI: 10.1109/AMPS.2011.6090430 ISBN: 978-1-61284-946-1**
• **QIN LIJUN ET AL: "Feasibility study of PMU based on IEEE 1588", ELECTRIC UTILITY DEREGULATION AND RESTRUCTURING AND POWER TECHNOLOGIES (DRPT), 2011 4TH INTERNATIONAL CONFERENCE ON, IEEE, 6 July 2011 (2011-07-06), pages 922-925, XP032039261, DOI: 10.1109/DRPT.2011.5994025 ISBN: 978-1-4577-0364-5**

**(Cont. next page)**

EP 2 713 172 B1

- JULIEN AMELOT ET AL: "Testing phasor measurement units using IEEE 1588 precision time protocol", PRECISION ELECTROMAGNETIC MEASUREMENTS (CPEM), 2012 CONFERENCE ON, IEEE, 1 July 2012 (2012-07-01), pages 230-231, XP032211011, DOI: 10.1109/CPEM.2012.6250886 ISBN: 978-1-4673-0439-9

**Description**

**Field of the invention**

The invention relates to a measurement apparatus for measuring electrical quantities in medium or low-voltage electricity distribution grids and to a method applying this apparatus.

**Background of the invention**

The electricity distribution grids are undergoing fundamental changes due to the integration of distributed generation sources with small inertia, uncertain dual load-generator behavior and distributed energy storage. Traditionally passive grids are being transformed to future distribution grids with active nature and are characterized by higher complexity and dynamics. A real-time monitoring system of medium/low-voltage electricity distribution grids is becoming more and more important (see Junqi Liu; Junjie Tang; Ponci, F.; Monti, A.; Muscas, C.; Pegoraro, P.A.; , "Trade-Offs in PMU Deployment for State Estimation in Active Distribution Grids," Smart Grid, IEEE Transactions on , vol.3, no.2, pp.915-924, June 2012).

Synchronized phasor measurement units (PMUs) have been widely applied to transmission grids for monitoring and control purposes (see A.G. Phadke, J.S. Thorp, Synchronized Phasor Measurements and Their Applications, Springer Science, 2008), where the assumption of steady state behavior for the electrical quantities like voltage and current is usually considered. However, in future electricity distribution grids the assumption does not hold anymore due to the increasing dynamic and non-stationary distortion in the grids. On the other hand, peculiar characteristics of electricity distribution grids such as limited power flow and highly distorted signal waveform may require specific limits on accuracy of phasor measurement (see Paolone M, Borghetti A and Nucci CA, "A synchrophasor estimation algorithm for the monitoring of active distribution networks in steady state and transient conditions", 17th Power Systems Computation Conference (PSCC'11), Stockholm, Sweden, Aug. 2011).

It is therefore a demand to provide real-time and high accuracy measurements of dynamic phasor, frequency and rate of change of frequency (ROCOF) in medium/low-voltage electricity distribution grids.

US 2006/0247874 discloses a phasor measurement system for computing synchronized phasor measurements. The phasor measurement system includes acquisition circuitry for acquiring voltage or current values from a power line, sampling circuitry for sampling the voltage or current values, and processing circuitry for computing a phasor and at least one time derivative of the phasor based on the sampled voltage or current values and for computing a synchronized phasor value based on the phasor and the at least one time derivative of the phasor.

US 2009/0099798 A1 discloses a power system oscillation detection device for use in an electric power system. A plurality of sample signals are acquired from the electrical power system via a plurality of intelligent electronic devices (IEDs) in communication with the power system. The power system oscillation detection device includes a real-time modal analysis module, a real-time mode identification module, and real-time decision and control logic. The real-time modal analysis module calculates modes of at least one of the signals, each mode including mode information. The real-time mode identification module together with the real-time decision and control logic determines, from the mode information, whether there is an undesirable oscillation in the electric power system and activates a remedial action.

**Summary of the invention**

It is an object of the invention to provide a measurement apparatus enabling real-time measurements of so-called dynamic synchrophasor, frequency and rate of change of frequency with high accuracy for medium/low-voltage electricity distribution grids.

This object is solved by a measurement apparatus as defined in claim 1.

The measurement apparatus enables real-time measurements of so-called dynamic phasors (synchrophasors) and frequency with high accuracy for medium/low-voltage electricity distribution grids. This measurement apparatus can provide in real-time accurate and synchronized measurements of dynamic voltage and current phasors, frequency and rate of change of the frequency information and measurements of harmonics. The selectable algorithms to calculate the electrical quantities such as a dynamic phasor calculation algorithm can achieve short response time to fast transient such as step changes of magnitude and phase with good level of accuracy. The measurement apparatus is useful for applications such as distribution state estimation, power quality monitoring and control. The computational unit can be any unit comprising a microprocessor suitable to execute calculation such as a computer, a server etc. In another embodiment the computational unit also provides frequency and rate of change of the frequency information. The sensing unit provides analog measurements of three phase voltages and currents with low measurement uncertainty. In other embodiments there might be more than one sensing unit providing analog measurements. Therefore the sensing units are inserted in an electricity distribution grid in order to be able to provide analog measurement signals of phase voltages and currents in the electrical grid with low measurement uncertainty. Skilled people can choose suitable sensing units and Analog-to-Digital-converter within the scope of the present invention.

The clock signal received by the Analog-to-Digital-converter might be based on UTC time. UTC time is the Coordinated Universal Time (UTC), which is the primary time standard by which the world regulates clocks and time. UTC is the time standard used for many internet and World Wide Web standards. The Network Time Protocol, designed to synchronize the clocks of computers over the Internet, encodes times using the UTC system. Computer servers, online services and other entities that rely on having a universally accepted time use UTC as it is more specific than GMT. If only limited precision is needed, clients can obtain the current UTC time from a number of official Internet UTC servers. For sub-microsecond precision, clients have to obtain the time from satellite signals or other more precise sources.

The electrical quantities of the electrical grids that are calculated from the digital signals by the computation unit can be any electrical quantity being of interest to monitor electricity grids. In another embodiment the electrical quantities of the electrical grids comprise dynamic phasors of voltage and current including time-varying amplitudes and/or phase information of the fundamental and harmonic sinusoidal voltage and current signals.

The calculations of the computation unit are based on Taylor-Fourier transformations. In an embodiment the suitable algorithm is a so-called modified Taylor-Fourier-Kalman filter method and/or an adaptive weighted least square method. The application of one of the algorithms depends on the specific requirements of the application scenarios in the computation unit. In another embodiment the algorithm for calculating the dynamic phasors is adapted to ensure the compliance requirement for measurement applications as defined in the synchrophasor standard. In a preferred embodiment the algorithm for calculating the dynamic phasors is adapted to simultaneously ensuring the compliance requirement for protection applications. A phasor measurement unit (PMU) or synchrophasor is a device which measures the electrical waves on an electricity grid, using a common time source for synchronization. The standards for synchrophasors are described in IEEE C37.118.1-2011 and C37.118.2-2011, which dealt with issues concerning use of PMUs in electric power systems. The specification describes standards for measurement, the method of quantifying the measurements, testing and certification requirements for verifying accuracy, and data transmission format and protocol for real-time data communication.

The external time information provided by the time synchronizing module provides time information applicable worldwide to synchronize events to the same time of occurance. In another embodiment the time synchronizing module is a global position unit obtaining signals from a navigation satellite system to provide the external time information. The time derived from signals from a navigation satellite system is very accurate and reliable and applicable as a worldwide reference. There are several navigation satellite systems already available or available soon, such as GPS, Galileo, Navistar-GPS or GLONASS. In an alternative embodiment the time synchronizing module is adapted to obtain a precision time protocol as the external time information via a communication module. The precision time protocol is a protocol used to synchronize clocks throughout a computer network.

On a local area network it achieves clock accuracy in the sub-microsecond range, making it suitable for measurement and control systems. PTP is defined in the IEEE 1588-2008 standard improving accuracy, precision and robustness of time information.

In another embodiment the measurement apparatus further comprises a communication module, where the measurement apparatus is adapted to process digital signals from other data acquisition systems received by the communication module additionally or alternatively. Therefore, the calculations can be performed also for electricity grids, where no sensing units of the measurement apparatus are installed.

In another embodiment the measurement apparatus further comprises one or more high accuracy large bandwidth transducers, where the measurement apparatus is calibrated with the transducers together. To achieve high accuracy of the phasor measurement it is important to keep the uncertainty caused by the voltage and current sensors as low as possible. In this invention specific high accuracy large bandwidth transducers are included into the measurement apparatus such that the overall measurement apparatus is calibrated with the transducers together, especially for medium-voltage applications. In this way, the uncertainty introduced by the transducers is included in the unit specifications, thus guaranteeing the user about the overall accuracy of the results, without the need to calibrate separately the external transducers, as required in devices currently used for synchrophasor measurement. The calibration based on the specified transducers enables to fulfill the measurement requirements on high accuracy for electricity distribution grids.

In another embodiment the measurement apparatus further comprises a storage unit to store the synchronized electrical quantities. In case of no communication connection, the stored synchronized electrical quantities can be transmitted later, when the communication connection is working again.

The invention further relates to a method as defined in claim 10.

In an embodiment the method comprises the further step of processing digital signals from other data acquisition systems received by a communication module of the measurement apparatus additionally or alternatively to the converted the analog signals provided by the sensing unit

In another embodiment the method comprises the further step of calibrating the measurement apparatus together with at least one high accuracy large bandwidth transducer.

In another embodiment the method comprises the further step of obtaining the external time information from signals from a navigation satellite system or from a precision time protocol (PTP).

**Brief description of the drawings**

These and other aspects of the invention will be apparent from and elucidated with reference to the embodiments described hereinafter.

Fig.1: an embodiment of the measurement apparatus according to the present invention;
Fig.2: an illustration of the adaptive weighted least square method.

**Detailed description of embodiments**

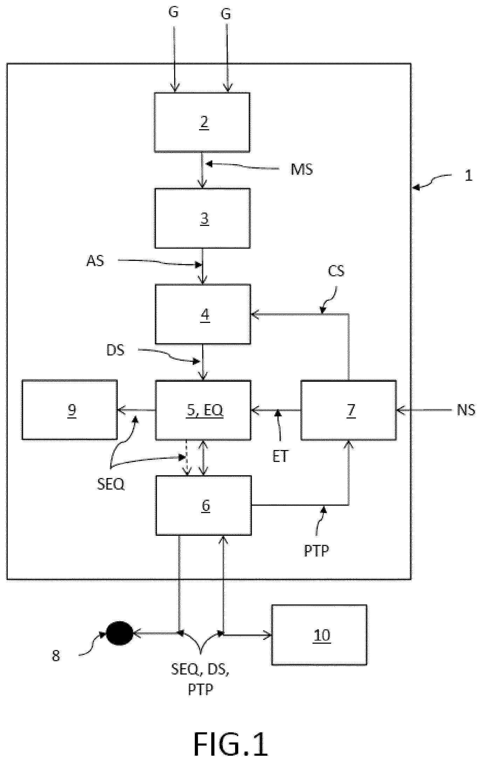

Fig.1 shows a measurement apparatus 1 for measuring electrical quantities in electricity distribution grids G. The measurement apparatus 1 comprises a sensing unit 2 to provide analog measurement signals MS of three phase voltages and currents in the electrical grid G with low measurement uncertainty. The measured signals are submitted to a signal conditioning unit 3 connected to the sensing unit 2, which makes the analog signals AS suitable for an Analog-to-Digital-converter 4. The Analog-to-Digital-converter 4 samples and converts the analog signals AS received from the signal conditioning unit (via a data connection) into digital signals DS, which are submitted to a computation unit 5 via suitable data connections. The received digital signals DS are used by the computation unit 5 for calculating electrical quantities EQ of the electrical grids G.

The measurement apparatus further comprises a time synchronizing module 7 to provide external time information ET to the computation unit 5, where the time synchronizing module 7 is either provided as a global position unit obtaining signals NS from a navigation satellite system or adapted to obtain a precision time protocol PTP as the external time information via the communication module 6. The synchronization of the PMUs, especially the measurement apparatus 1, can be done by acquiring GPS signal as a signal NS of a navigation satellite system by a dedicated GPS module hardware that can provide time synchronization accuracy within $\pm 90$ ns. However, the integration of one GPS module in a synchronized phasor measurement unit (PMUs) results in higher cost. The Precision Time Protocol (PTP) - IEEE 1588-2008 is a suitable synchronization technique particularly satisfying the high accuracy requirements of IEEE Synchrophasor standard. The use of PTP can be in software-only and hardware-assisted configurations. In this invention both GPS based and the PTP based synchronization method can be applied for the proposed measurement apparatus 1. In a measurement infrastructure for the electricity distribution grids G with several phasor measurement devices, the measurement apparatus 1 equipped with a GPS module as the time synchronizing module 7 can deduce synchronization signal with high accuracy and can serve as a master to distribute the synchronization signal. The other phasor measurement units can then synchronize with the master unit via PTP method without a dedicated GPS module 7. In this way the overall cost of the infrastructure can be reduced.

The computation unit 5 selects a suitable algorithm according to specific requirements of different application areas to calculate the electrical quantities EQ, where the Analog-to-Digital-converter 4 receives R a clock signal from the time synchronization module to synchronize the signal sampling. Furthermore the computation unit 5 synchronizes the time-tagged electrical EQ quantities with the external time information ET obtained from the time synchronizing module 7 to provide synchronized electrical quantities SEQ, which are transmitted to an external data collection point 8 by the communication module 6 via a suitable communication connection connected to the communication module 6. The measurement apparatus 1 further comprises a storage unit 9 to store the synchronized electrical quantities SEQ received from the computation unit 5. In this embodiment the computation unit is furthermore adapted to process digital signals DS received from other data acquisition systems 10 additionally or alternatively. To receive the digital signals provided by other data acquisition systems 10 the communication module 6 establishes a suitable communication connection connected to the data acquisition systems 11. In this embodiment the measurement apparatus 1 further comprises one or more high accuracy large bandwidth transducers to calibrate the measurement apparatus 1. In electricity distribution grids G requirements on higher accuracy of the phasor measurement comparing to transmission grids is expected due to smaller phase angle differences between buses and highly distorted signal waveform. To achieve high accuracy of the phasor measurement it is important to keep the uncertainty caused by the voltage and current sensors as low as possible. In this invention specific high accuracy large bandwidth transducers are included into the measurement apparatus 1 such that the overall measurement apparatus 1 is calibrated with the transducers together, especially for medium-voltage applications. In this way, the uncertainty introduced by the transducers is included in the unit specifications, thus guaranteeing the user about the overall accuracy of the results, without the need to calibrate separately the external transducers, as required in devices currently used for synchrophasor measurement

The communication module 6 serves as an interface to transmit at least the synchronized electrical quantities SEQ with external network and devices. The communication module can also receive signals or data DS to be processed by the measurement apparatus 1 and the messages for remote control through the different interfaces. Depending on the different application requirements diverse modules based different communication technologies can be integrated into the communication module 6 such as for Ethernet, Power Line Communication and Mobile Communication (GSM, 3G and even the novel 4G mobile communication technology). In addition, the data models for the measurements are implemented in compliance with IEC 61850 Standard which enables the interoperability of the measurement apparatus 1 with external devices and systems 8, 10 from different providers.

The dynamic phasor calculation is based on the so-called Taylor-Fourier transformation. Considering that a signal composed of a DC component, the fundamental and harmonic components with time varying amplitude and phase is formulated by

$$
\begin{aligned}
s(t) &= a_0(t) + \sum_{m=1}^{N_h} a_m(t)\cos(j\omega_m t + \varphi_m(t)) \\
&= a_0(t) + \sum_{m=1}^{N_h} Re\left\{p_m(t)e^{j\omega_m t}\right\}
\end{aligned}
$$

And the dynamic phasor $p_m(t)$ of the m-th frequency component cont (P1) the signal s(t) is defined as:

$$
p_m(t) = a_m(t)e^{j\varphi_m(t)} \qquad (P2)
$$

By taking the Taylor equation, the dynamic phasor of m-th frequency component can be approximated by

$$
p_m(t) \approx \sum_{i=0}^{K} p_m^{(i)}(t_0)\frac{(t-t_0)^i}{i!} \qquad (P3)
$$

In the computation unit with two algorithms, the so-called Taylor-Fourier-Kalman Filter method and/or the adaptive weighted least square method, can be used alternatively depending on the specific requirements of the application scenarios to estimate the fundamental and harmonic dynamic phasors and its derivates according to the Taylor-Fourier und steady state, transient and distorted conditions. In addition, the frequency and the rate of the change of frequency of each frequency component can be calculated based on the estimated dynamic phasor and its derivates according to

$$
\begin{aligned}
2\pi f_{mK}(t) &= \omega_m + \varphi_{mK}^{(1)}(t) \\
&= \omega_m + \sum_{i=0}^{K-1} \varphi_m^{(i+1)}(t_0)\frac{(t-t_0)^i}{i!}
\end{aligned} \qquad (P4)
$$

The Taylor-Fourier-Kalman Filter method is described in more details in the following:

Improved state space model of dynamic phasor for Modified Taylor-Fourier-Kalman Filter:

Considering that a signal composed of the fundamental and harmonic components is formulated by

$$s(t) = a_0(t) + \sum_{m=1}^{N_h} a_m(t) \cos(j\omega_m t + \varphi_m(t)) \tag{1}$$

$$= a_0(t) + \sum_{m=1}^{N_h} Re\left\{p_m(t)e^{j\omega_m t}\right\}$$

where $\omega_m = m^*\omega_1$. $N_h$ is the highest order of harmonics. $a_0(t)$ represents the DC component which could be a DC offset or a decaying DC component possibly present in the signal. $a_m(t)$ and $\varphi_m(t)$ are the time varying amplitude and phase of the m-th frequency component respectively.

Thus, $p_m(t)$ represents the dynamic phasor of m-th frequency component contained in the signal $s(t)$.

$$p_m(t) = a_m(t)e^{j\varphi_m(t)} \tag{2}$$

The dynamic phasor $p_m(t)$ can be approximated by a K-th order Taylor polynomial

$$p_m(t) \approx p_{mK}(t) = \sum_{i=0}^{K} p_m^{(i)}(t_0)\frac{(t-t_0)^i}{i!} \tag{3}$$

Subsequently, the state transition equation for the truncated dynamic phasor and its derivatives of the m-th frequency component is expressed as

$$\mathbf{p}_{mK}(t) = \mathbf{\Phi}_K(\tau)\mathbf{p}_{mK}(t_0) \tag{4}$$

where $\mathbf{p}_{mK}(t) = \left[p_{mK}^{(0)}(t) \quad p_{mK}^{(1)}(t) \quad \cdots \quad p_{mK}^{(K)}(t)\right]^T$ is the state vector and the state transition matrix is given by

$$\mathbf{\Phi}_K(\tau) = \begin{bmatrix} 1 & \tau & \cdots & \dfrac{\tau^K}{K!} \\ & 1 & \cdots & \dfrac{\tau^{K-1}}{(K-1)!} \\ & & \ddots & \vdots \\ & & & 1 \end{bmatrix} \tag{5}$$

Considering the truncated dynamic phasor model defined in (5), the truncated signal model is

$$s_K(t) = \sum_{m=1}^{N_h} Re\left\{\mathbf{h}^T\mathbf{p}_{mK}(t)e^{j\omega_m t}\right\} \tag{6}$$

with $\mathbf{h}^T = [1\ 0\cdots0]$ of the dimension $1 \times (K+1)$.

In order to obtain a linear time-invariant state space model for the dynamic phasor estimation, we consider the rotating phasor $r_m(t)$ for the m-th frequency component given by

$$r_m(t) = p_m(t)e^{j\omega_m t} \tag{7}$$

The vector $r_{mK}(t)$ consisting of the truncated rotating phasor and its derivatives based on K-th order Taylor polynomials can be obtained by

$$\mathbf{r}_{mK}(t) = \begin{bmatrix} r_{mK}^{(0)}(t) \\ r_{mK}^{(1)}(t) \\ \vdots \\ r_{mK}^{(K)}(t) \end{bmatrix} = e^{j\omega_m t} \cdot \mathbf{M}_{mK} \cdot \mathbf{p}_{mK}(t) \tag{8}$$

with $\boldsymbol{p}_{mK}(t)$ defined in (4) and an invertible matrix $\mathbf{M}_{mK}$ given by

$$\mathbf{M}_{mK} = \begin{bmatrix} 1 & 0 & \cdots & 0 \\ j\omega_m & 1 & \cdots & 0 \\ \vdots & \vdots & \ddots & \vdots \\ (j\omega_m)^K & K(j\omega_m)^{K-1} & \cdots & 1 \end{bmatrix} \in \mathbb{C}^{(K+1)\times(K+1)} \tag{9}$$

where the element $M_{pq}$ of the matrix $\mathbf{M}_{mK}$ in row p and column q with $p > q$ is given by

$$\mathcal{M}_{pq} = \binom{p-1}{q-1}(j\omega_m)^{p-q} \tag{10}$$

For a given $t_0$ the following equation holds

$$\mathbf{r}_{mK}(t_0) = e^{j\omega_m t_0} \cdot \mathbf{M}_{mK} \cdot \mathbf{p}_{mK}(t_0) \tag{11}$$

By substituting (8) and (11) into (4), the state transition model of the vector $\boldsymbol{r}_{mK}(t)$ is obtained by

$$\mathbf{r}_{mK}(t) = e^{j\omega_m \tau} \cdot \mathbf{M}_{mK} \cdot \Phi_K(\tau) \cdot \mathbf{M}_{mK}^{-1} \cdot \mathbf{r}_{mK}(t_0) \tag{12}$$

Assuming $t_0 = (n\text{-}1)\tau$ and $t = n\tau$ with $\tau$ equal to a given sampling time Ts, the discrete state transition model of $\mathbf{r}_{mK}[n]$ can be formulated by

$$\mathbf{r}_{mK}[n] = e^{j\omega_m \tau} \cdot \Psi_{mK}(\tau) \cdot \mathbf{r}_{mK}[n-1] \tag{13}$$

with $\Psi_{mK}(\tau) = \mathbf{M}_{mK} \cdot \Phi_K(\tau) \cdot \mathbf{M}_{mK}^{-1}$.

Considering the discrete state transition model for the single m-th frequency component in (13), the discrete state space model for the signal in (1) consisting of all frequency components is given by

$$\mathbf{x}[n] = \mathbf{\Lambda}\mathbf{x}[n-1] + \mathbf{F}\mathbf{v}[n] \tag{14}$$

with

$$\mathbf{x}[n] = \begin{bmatrix} r_0[n] & \mathbf{r}_{1K}[n] & \bar{\mathbf{r}}_{1K}[n] & \cdots & \mathbf{r}_{N_h K}[n] & \bar{\mathbf{r}}_{N_h K}[n] \end{bmatrix}^T$$

$$\mathbf{\Lambda} = \begin{bmatrix} \mathbf{A}_0 & & & & \\ & \mathbf{A}_1 & & & \\ & & \mathbf{A}_2 & & \\ & & & \ddots & \\ & & & & \mathbf{A}_{N_h} \end{bmatrix} \tag{15}$$

in which $r_0[n]$ and $\mathbf{A}_0$ correspond to the DC component and

$$\mathbf{A}_m = \begin{bmatrix} e^{j\omega_m \tau}\Psi_{mK}(\tau) & 0 \\ 0 & e^{-j\omega_m \tau}\bar{\Psi}_{mK}(\tau) \end{bmatrix} \text{ with } m \in \{1, 2 \cdots N_h\} \tag{16}$$

where $\psi_{mK}(\tau)$ and $\mathbf{r}_{mK}[n]$ with respect to the frequency component $\omega_m$ are defined in (13), and $\bar{\Psi}mK(\tau)$ and $\bar{r}_{mK}[n]$ are their complex conjugate. $\mathbf{v}[n]$ represents a vector of virtual white Gaussian noise. The matrix $\mathbf{F}$ is chosen equal to an identity matrix $\mathbf{I}$.

The measurement equation, which is the discrete signal $s[n]$ corrupted by a white Gaussian noise $\omega[n]$, is defined as

$$y[n] = s[n] + \omega[n] = \mathbf{\Theta}\mathbf{x}[n] + \omega[n] \tag{17}$$

where the measurement matrix is $\Theta = [h^T h^T \cdots h^T]$.

<u>Estimation of the Dynamic Phasors based on Kalman Filter Approach:</u>

Based on the resulting state equation in (14) and the measurement equation in (17) the standard discrete Kalman Filter is applied to estimate the rotating vectors $\mathbf{r}_{mK}[n]$ according to

1) Prediction

    a) State prediction

$$\hat{\mathbf{x}}^-[n] = \mathbf{\Lambda}\hat{\mathbf{x}}[n-1] \tag{18}$$

    b) Covariance prediction

$$\mathbf{P}^-[n] = \mathbf{\Lambda}\mathbf{P}[n-1]\mathbf{\Lambda}^T + \mathbf{F}\mathbf{F}^T\sigma_{\mathbf{v}}^2 \tag{19}$$

2) Measurement update

    a) Kalman gain update

$$\mathbf{K}[n] = \mathbf{P}^-[n]\mathbf{\Theta}^T(\mathbf{\Theta}\mathbf{P}^-[n]\mathbf{\Theta}^T + \sigma_{\omega}^2)^{-1} \tag{20}$$

    b) State update

$$\hat{\mathbf{x}}[n] = \hat{\mathbf{x}}^-[n] + \mathbf{K}[n](s[n] - \mathbf{\Theta}\hat{\mathbf{x}}^-[n]) \tag{21}$$

c) Covariance update

$$\mathbf{P}[n] = (\mathbf{I} - \mathbf{K}[n]\mathbf{\Theta})\mathbf{P}^-[n] \tag{22}$$

where $\sigma_v^2$ and $\sigma_w^2$ are the variances of the input and measurement noise respectively.

The vector $\hat{\mathbf{p}}_{mK}[n]$ with the estimated dynamic phasor and its derivatives for m-th frequency component in discrete time is then obtained from estimated rotating phasor $\hat{\mathbf{r}}_{mK}[n]$ by

$$\hat{\mathbf{p}}_{mK}[n] = e^{-j\omega_m n\tau} \cdot \mathbf{M}_{mK}^{-1} \cdot \hat{\mathbf{r}}_{mK}[n] \tag{23}$$

Frequency Estimation:

The amplitude and phase of the dynamic phasor $p_m(t)$ at $t = t_0$ can be obtained

$$
\begin{aligned}
a_m(t_0) &= 2|p_m(t_0)| \\
\varphi_m(t_0) &= \angle p_m(t_0)
\end{aligned}
\tag{24}
$$

The relationships between the phasor estimates and the derivatives of amplitude and phase are obtained by taking the $K$-th derivatives at $t = t_0$ as

$$
\begin{aligned}
a_m^{(1)}(t_0) &= 2\mathrm{Re}\left\{ p_m^{(1)}(t_0)e^{-j\varphi_m(t_0)} \right\} \\
\varphi_m^{(1)}(t_0) &= \frac{2\mathrm{Im}\left\{ p_m^{(1)}(t_0)e^{-j\varphi_m(t_0)} \right\}}{a_m(t_0)} \\
a_m^{(2)}(t_0) &= 4\mathrm{Re}\left\{ p_m^{(2)}(t_0)e^{-j\varphi_m(t_0)} + a_m(t_0)[\varphi^{(1)}(t_0)]^2 \right\} \\
\varphi_m^{(2)}(t_0) &= \frac{4\mathrm{Im}\left\{ p_m^{(2)}(t_0)e^{-j\varphi_m(t_0)} \right\} - 2a_m^{(1)}(t_0)\varphi_m^{(1)}(t_0)}{a_m(t_0)}
\end{aligned}
\tag{25}
$$

Considering the general definition of the so-called instantaneous frequency as

$$f(t) = \frac{1}{2\pi}\frac{d}{dt}\arg(s(t)) \tag{26}$$

the instantaneous frequency $f_{mK}(t)$ for the m-th frequency component of the signal in (1) can be approximated by $K$-th Taylor expansion according to

$$
\begin{aligned}
2\pi f_{mK}(t) &= \omega_m + \varphi_{mK}^{(1)}(t) \\
&= \omega_m + \sum_{i=0}^{K-1} \varphi_m^{(i+1)}(t_0)\frac{(t-t_0)^i}{i!}
\end{aligned}
\tag{27}
$$

Then the frequency at discrete time sequence is obtained by considering again $t_0 = (n-1)\tau$ and $t = n\tau$,

$$f_{mK}[n] = \frac{\omega_m}{2\pi} + \frac{1}{2\pi}\sum_{i=0}^{K-1} \varphi_m^{(i+1)}[n-1]\frac{\tau^i}{i!} \tag{28}$$

<u>The adaptive weighted least square method</u> is described in more details in the following:

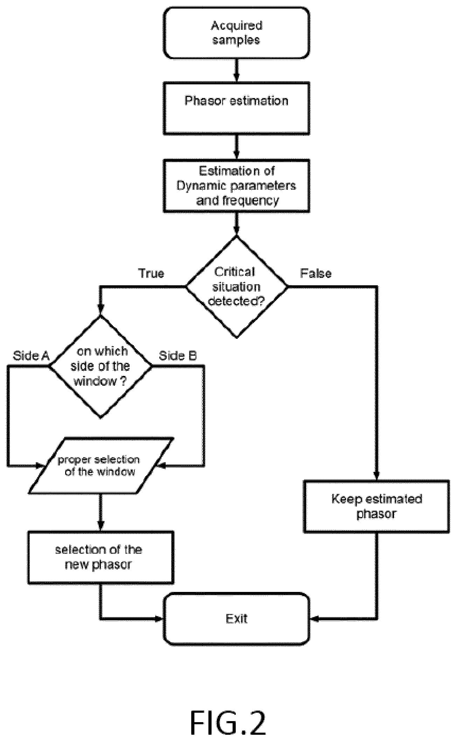

This method allows a high level of accuracy for measurement applications while also ensuring a fast ability to adapt to fast transients through the evaluation of dynamic parameters. Fig.2 shows an illustration of the adaptive weighted least square method. To obtain a faster response to abrupt dynamic changes of phasors, like amplitude or phase steps, an adaptive approach is proposed. The underlying idea is to detect degradation in the Taylor Fourier estimation, due to a mismatch between the signal and the chosen model, and to adapt the estimation algorithm to changing conditions.
The algorithm follows main steps:

1. Computation of phasors by means of two different weighting functions
2. Detection of critical conditions.
3. Choices of the best estimations.

In the first step two phasors Pa and Pb are calculated on two portions of the observation window (Side A and Side B), splitting the weighting matrix W in two contributions Wa and Wb, so that W=Wa+Wb.
This means employing different samples with different weights, thus allowing emphasizing or minimizing their impact on the estimation.
In particular the phasors can be derived by the following matricial equation:

$$P_i = (B^H W_i B)^{-1} B^H W_i s \qquad\qquad (29)$$

Where the vector s contains the acquired samples, *i = a* or *b, B is the standard Taylor-Fourier model matrix.*
The classical Taylor-Fourier synchrophasor P can be calculated from Pa and Pb by a simple reconstruction equation, a sort of "weighted" average

$$P = (Ra*Pa) + (Rb*Pb) \qquad\qquad (30)$$

where Ra and Rb are the recombination matrices.
The recognition of a fast transient is allowed by a rapid change of the dynamic values that compose the dynamic synchrophasor P (amplitude, phase and their derivatives and derived parameters such as frequency).
The choice of the best estimate matches with the choice of the side of the acquisition window that is not affected by fast transient. Consequently, the choice of the phasors Pa and Pb is based on the comparison of dynamic parameters (amplitude, phase and its derivatives) of the phasors Pa and Pb.
While the invention has been illustrated and described in details in the drawings and foregoing description, such illustration and description are to be considered illustrative or exemplary and not restrictive; the invention is not limited to the disclosed embodiments.
Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference sign in the claims should not be construed as limiting the scope.

**List of reference signs**

1      measurement apparatus
2      sensing unit
3      conditioning unit
4      Analog-to-Digital-converter
5      computation unit
6      communication module
7      time synchronizing module
8      external data collection point
9      storage unit

10     other data acquisition system

AS     analog signals
CS     clock signal
DS     digital signals
EQ     electrical quantities
ET     external time information
G     electricity distribution grid
MS     measurement signals
NS     signals from satellite navigation systems
PTP     precision time protocol
SEQ     synchronized electrical quantities

**Claims**

1. A measurement apparatus (1) comprising at least one sensing unit (2) suitable to provide analog measurement signals (MS) of phase voltages and currents in an electrical grid (G) with low measurement uncertainty and a signal conditioning unit (3) connected to the sensing unit (2) making the analog signals suitable for an Analog-to-Digital-converter (4) sampling and converting the analog signals (AS) into digital signals (DS), a computation unit (5) for calculating electrical quantities (EQ) of the electrical grid (G) from the digital signals (DS), a communication module (6) and a time synchronizing module (7) for providing external time information (ET), where the computation unit (5) selects a suitable algorithm according to specific requirements of different application areas to calculate the electrical quantities (EQ), where the Analog-to-Digital-converter (4) receives a clock signal (CS) from the time synchronization module (7) to synchronize the sampling of the signals (AS, DS), where the computation unit (5) is adapted to synchronize the electrical quantities (EQ) with the external time information (ET) obtained from the time synchronizing module (7) to provide synchronized electrical quantities (SEQ), where the measurement apparatus (1) is adapted to transmit the synchronized electrical quantities (SEQ) by the communication module (6) to an external data collection point (8), **characterized in that**,
the measurement apparatus (1) is for measuring synchronized dynamic phasors in medium or low-voltage electricity distribution grids (G), wherein the computation unit (5) uses an adaptive weighted least square method to calculate the electrical quantities (EQ).

2. The measurement apparatus (1) as claimed in claim 1, **characterized in that** the time synchronizing module (7) is a global position unit obtaining signals (NS) from a navigation satellite system to provide the external time information (ET).

3. The measurement apparatus (1) as claimed in claim 1, **characterized in that** the time synchronizing module (7) is adapted to obtain a precision time protocol (PTP)

4. The measurement apparatus (1) as claimed in one of the preceding claims, **characterized in that** the electrical quantities (EQ) of the electrical grids (G) comprise dynamic phasors of voltage and current including time-varying amplitudes and/or phase information of the fundamental and harmonic sinusoidal voltage and current signals.

5. The measurement apparatus (1) as claimed in claim 4, **characterized in that** the algorithm for calculating the dynamic phasors is adapted to ensure the compliance requirement for measurement applications as defined in the synchrophasor standard IEEE C37.118.1-2011 and C37.118.2-2011.

6. The measurement apparatus (1) as claimed in claim 5, **characterized in that** the algorithm for calculating the dynamic phasors is adapted to simultaneously allow ensuring the compliance requirement for protection applications as defined in synchrophasor standard.

7. The measurement apparatus (1) as claimed in one of the preceding claims, **characterized in that** the computational unit (5) also provides frequency and rate of change of the frequency information in the medium/low-voltage electricity distribution grids.

8. The measurement apparatus (1) as claimed in one of the preceding claims, **characterized in that** the measurement apparatus (1) is adapted to process digital signals (DS) from other data acquisition systems (10) received by the communication module (6) additionally or alternatively.

9. The measurement apparatus (1) as claimed in one of the preceding claims, **characterized in that** the measurement apparatus (1) further comprises a storage unit (9) to store the synchronized electrical quantities (SEQ).

10. Method for determining electrical quantities (EQ) in electricity distribution grids (G) using a measurement apparatus (1) as claimed in claim 1 comprising the following steps:

   - Providing analog measurement signals (MS) of phase voltages and currents in the electrical grid (G) by a sensing unit (2) with low measurement uncertainty;
   - Making the analog signals (AS) suitable for a Analog-to-Digital-converter (4) by a signal conditioning unit (3);
   - Sampling and converting the analog signals (AS) into digital signals (DS) by the Analog-to-Digital-converter (4);
   - calculating electrical quantities (EQ) of the electrical grids (G) from the digital signals (DS) by a computation unit (5), where the computation unit (5) selects a suitable algorithm according to specific requirements of different application areas including using an adaptive weighted least square method to calculate the electrical quantities (EQ);
   - receiving a clock signal (CS) from the time synchronization module (7) by the Analog-to-Digital-converter (4) to synchronize the signal sampling;
   - Providing external time information (ET) by a time synchronizing module (7);
   - Synchronizing the time-tagged electrical quantities (EQ) with the external time information (ET) obtained from the time synchronizing module (7) by the computation unit (5) to provide synchronized electrical quantities (SEQ); and
   - transmitting the synchronized electrical (SEQ) quantities via a communication module (6) of the measurement apparatus (1) to an external data collection point (8).

11. The method as claimed in claim 10, **characterized in that** the method comprises the further step of:

   - Processing digital signals (DS) from other data acquisition systems (10) received by a communication module (6) of the measurement apparatus (1) additionally or alternatively to the converted analog signals (AS) provided by the sensing unit (2).

12. The method as claimed in one of the claims 10 to 11, **characterized in that** the method comprises the further step of

   - Obtaining the external time information (ET) from signals (NS) from a navigation satellite system or from a precision time protocol (PTP).

## Patentansprüche

1. Messvorrichtung (1) mit mindestens einer Sensoreinheit (2), die in der Lage ist, analoge Mess-Signale (MS) von Phasenspannungen und -strömen in einem Stromnetz (G) mit niedriger Messunsicherheit zu erzeugen, und mit einer mit der Sensoreinheit (2) verbundenen Signalkonditionierungseinheit (3), welche die Analogsignale zur Eignung für einen Analog-/Digital-Konverter (4) konditioniert, der die Analogsignale (AS) abtastet und zu Digitalsignalen (DS) konvertiert, einer Recheneinheit (5) zum Berechnen elektrischer Größen (EQ) des Stromnetzes (G) aus den Digitalsignalen (DS), einem Kommunikationsmodul (6) und einem Zeitsynchronisationsmodul (7) zum Erzeugen externer Zeitinformation (ET), wobei die Recheneinheit (5) einen geeigneten Algorithmus entsprechend spezifischer Erfordernisse verschiedener Anwendungsbereiche wählt, um die elektrischen Größen (EQ) zu berechnen, wobei der Analog-/Digital-Konverter (4) ein Taktsignal (CS) von dem Zeitsynchronisationsmodul (7) empfängt, um das Abtasten der Signale (AS, DS) zu synchronisieren, wobei die Recheneinheit (5) in der Lage ist, die elektrischen Größen (EQ) mit der aus dem Zeitsynchronisationsmodul (7) erhaltenen externen Zeitinformation (ET) zu synchronisieren, um synchronisierte elektrische Größen (SEQ) zu erzeugen, wobei die Messvorrichtung (1) in der Lage ist, die synchronisierten elektrischen Größen (SEQ) mittels des Kommunikationsmoduls (6) zu einem externen Datensammelpunkt (8) zu übertragen, **dadurch gekennzeichnet, dass** die Messvorrichtung (1) zum Messen synchronisierter dynamischer Phasoren in Mittel- oder Niederspannungs-Stromverteilungsnetzen (G) vorgesehen ist, wobei die Recheneinheit (5) ein adaptives gewichtetes Verfahren der kleinsten Quadrate verwendet, um die elektrischen Größen (EQ) zu berechnen.

2. Messvorrichtung (1) nach Anspruch 1, **dadurch gekennzeichnet, dass** das Zeitsynchronisationsmodul (7) eine globale Positionseinheit ist, die Signale (NS) von einem Navigationssatellitensystem erhält, um die externe Zeitinformation (ET) zu erzeugen.

3. Messvorrichtung (1) nach Anspruch 1, **dadurch gekennzeichnet, dass** das Zeitsynchronisationsmodul (7) zum Erstellen eines Präzisionszeitprotokolls (PTP) in der Lage ist.

4. Messvorrichtung (1) nach einem der vorhergehenden Ansprüche, **dadurch gekennzeichnet, dass** die elektrischen Größen (EQ) der Stromnetze (G) dynamische Spannungs- und Stromphasoren mit zeitlich variierenden Amplituden und/oder Phaseninformation der Grundwellen- und Oberwellen-Sinusspannungs- und Stromsignale aufweisen.

5. Messvorrichtung (1) nach Anspruch 4, **dadurch gekennzeichnet, dass** der Algorithmus zum Berechnen der dynamischen Phasoren derart ausgelegt ist, dass das Konformitätserfordernis für Mess-Anwendungen gemäß der Definition in der Synchrophasor-Norm IEEE C37.118.1-2011 und C37.118.2-2011 eingehalten wird.

6. Messvorrichtung (1) nach Anspruch 5, **dadurch gekennzeichnet, dass** der Algorithmus zum Berechnen der dynamischen Phasoren derart ausgelegt ist, dass gleichzeitig das Konformitätserfordernis für Schutz-Anwendungen gemäß der Definition in der Synchrophasor-Norm eingehalten wird.

7. Messvorrichtung (1) nach einem der vorhergehenden Ansprüche, **dadurch gekennzeichnet, dass** die Recheneinheit (5) ferner die Frequenz und die Veränderungsrate der Frequenzinformation in den Mittel-/Niederspannungs-Stromverteilungsnetzen liefert.

8. Messvorrichtung (1) nach einem der vorhergehenden Ansprüche, **dadurch gekennzeichnet, dass** die Messvorrichtung (1) in der Lage ist, von anderen Datenerfassungssystemen (10) ausgegebene Digitalsignale (DS) zu verarbeiten, die seitens des Kommunikationsmoduls (6) zusätzlich oder alternativ empfangen werden.

9. Messvorrichtung (1) nach einem der vorhergehenden Ansprüche, **dadurch gekennzeichnet, dass** die Messvorrichtung (1) ferner eine Speichereinheit (9) zum Speichern der synchronisierten elektrischen Größen (SEQ) aufweist.

10. Verfahren zum Bestimmen elektrischer Größen (EQ) in Stromverteilungsnetzen (G) mittels einer Messvorrichtung (1) nach Anspruch 1, mit den folgenden Schritten:

Erzeugen analoger Mess-Signale (MS) von Phasenspannungen und -strömen in dem Stromnetz (G) mittels einer Sensoreinheit (2) mit niedriger Messunsicherheit;
Konditionieren der Analogsignale (AS) zur Eignung für einen Analog-/Digital-Konverter (4) mittels einer Signalkonditionierungseinheit (3);
Abtasten der Analogsignale (AS) und Konvertieren derselben zu Digitalsignalen (DS) mittels des Analog-/Digital-Konverters (4);
Berechnen elektrischer Größen (EQ) der Stromnetze (G) aus den Digitalsignalen (DS) mittels einer Recheneinheit (5), wobei die Recheneinheit (5) einen geeigneten Algorithmus entsprechend spezifischer Erfordernisse verschiedener Anwendungsbereiche einschließlich der Verwendung eines adaptiven gewichteten Verfahrens der kleinsten Quadrate verwendet, um die elektrischen Größen (EQ) zu berechnen;
Empfangen eines Taktsignals (CS) von dem Zeitsynchronisationsmodul (7) seitens des Analog-/Digital-Konverters (4), um das Signal-Abtasten zu synchronisieren;
Erzeugen externer Zeitinformation (ET) mittels eines Zeitsynchronisationsmoduls (7);
Synchronisieren der zeitlich markierten elektrischen Größen (EQ) mit der aus dem Zeitsynchronisationsmodul (7) erhaltenen externen Zeitinformation (ET) mittels der Recheneinheit (5), um synchronisierte elektrische Größen (SEQ) zu erzeugen; und
Übertragen der synchronisierten elektrischen Größen (SEQ) über ein Kommunikationsmodul (6) der Messvorrichtung (1) zu einem externen Datensammelpunkt (8).

11. Verfahren nach Anspruch 10, **dadurch gekennzeichnet, dass** das Verfahren folgenden weiteren Schritt umfasst: Verarbeiten von Digitalsignalen (DS) von anderen Datenerfassungssystemen (10), die seitens eines Kommunikationsmoduls (6) der Messvorrichtung (1) zusätzlich oder alternativ zu den von der Sensoreinheit (2) zugeführten konvertierten Analogsignalen (AS) empfangen werden.

12. Verfahren nach einem der Ansprüche 10 bis 11, **dadurch gekennzeichnet, dass** das Verfahren folgenden weiteren Schritt aufweist:

Erhalt der externen Zeitinformation (ET) aus Signalen (NS) von einem Navigationssatellitensystem oder von einem Präzisionszeitprotokoll (PTP).

## Revendications

1. Appareil de mesure (1) comprenant au moins une unité de détection (2) appropriée pour fournir des signaux de mesure analogiques (MS) de tensions et de courants de phase dans un réseau électrique (G) avec une faible incertitude de mesure et une unité de conditionnement de signal (3) connectée à l'unité de détection (2) rendant les signaux analogiques appropriés pour un convertisseur analogique-numérique (4) échantillonnant et convertissant les signaux analogiques (AS) en signaux numériques (DS), une unité de calcul (5) pour calculer des quantités électriques (EQ) du réseau électrique (G) à partir des signaux numériques (DS), un module de communication (6) et un module de synchronisation de temps (7) pour fournir des informations de temps externe (ET), où l'unité de calcul (5) sélectionne un algorithme approprié selon des exigences spécifiques de zones d'application différentes pour calculer les quantités électriques (EQ), où le convertisseur analogique-numérique (4) reçoit un signal d'horloge (CS) en provenance du module de synchronisation de temps (7) pour synchroniser l'échantillonnage des signaux (AS, DS), où l'unité de calcul (5) est adaptée pour synchroniser les quantités électriques (EQ) avec les informations de temps externe (ET) obtenues à partir du module de synchronisation de temps (7) pour fournir des quantités électriques synchronisées (SEQ), où l'appareil de mesure (1) est adapté pour transmettre les quantités électriques synchronisées (SEQ) par le module de communication (6) à un point de collecte de données externe (8), **caractérisé en ce que**,
   l'appareil de mesure (1) sert à mesurer des phaseurs dynamiques synchronisés dans des réseaux de distribution d'électricité moyenne ou basse tension (G), dans lequel l'unité de calcul (5) utilise une méthode des moindres carrés pondérés adaptative pour calculer les quantités électriques (EQ).

2. Appareil de mesure (1) selon la revendication 1, **caractérisé en ce que** le module de synchronisation de temps (7) est une unité mondiale de positionnement obtenant des signaux (NS) à partir d'un système de navigation par satellite pour fournir des informations de temps externe (ET).

3. Appareil de mesure (1) selon la revendication 1, **caractérisé en ce que** le module de synchronisation de temps (7) est adapté pour obtenir un protocole de temps de précision (PTP).

4. Appareil de mesure (1) selon l'une des revendications précédentes, **caractérisé en ce que** les quantités électriques (EQ) des réseaux électriques (G) comprennent des phaseurs dynamiques de tension et de courant incluant des amplitudes variant dans le temps et/ou des informations de phase des signaux de tension et de courant sinusoïdaux fondamentaux et harmoniques.

5. Appareil de mesure (1) selon la revendication 4, **caractérisé en ce que** l'algorithme pour calculer les phaseurs dynamiques est adapté pour garantir l'exigence de conformité pour des applications de mesure telles que définies dans la norme IEEE de synchrophaseur C37.118.1-2011 et C37.118.2-2011.

6. Appareil de mesure (1) selon la revendication 5, **caractérisé en ce que** l'algorithme pour calculer les phaseurs dynamiques est adapté pour permettre simultanément de garantir l'exigence de conformité pour des applications de protection telles que définies dans la norme de synchrophaseur.

7. Appareil de mesure (1) selon l'une des revendications précédentes, **caractérisé en ce que** l'unité de calcul (5) fournit également une fréquence et un taux de changement des informations de fréquence dans les réseaux de distribution d'électricité moyenne et basse tension.

8. Appareil de mesure (1) selon l'une des revendications précédentes, **caractérisé en ce que** l'appareil de mesure (1) est adapté pour traiter des signaux numériques (DS) provenant d'autres systèmes d'acquisition de données (10) reçus par le module de communication (6) en plus ou en variante.

9. Appareil de mesure (1) selon l'une des revendications précédentes, **caractérisé en ce que** l'appareil de mesure (1) comprend en outre une unité de stockage (9) pour stocker les quantités électriques synchronisées (SEQ).

10. Procédé de détermination de quantités électriques (EQ) dans des réseaux de distribution d'électricité (G) à l'aide d'un appareil de mesure (1) tel que revendiqué dans la revendication 1, comprenant les étapes suivantes :

- la fourniture de signaux de mesure analogiques (MS) de tensions et de courants de phase dans le réseau électrique (G) par une unité de détection (2) avec une faible incertitude de mesure ;
- le fait de rendre les signaux analogiques (AS) appropriés pour un convertisseur analogique-numérique (4) par une unité de conditionnement de signal (3) ;
- l'échantillonnage et la conversion des signaux analogiques (AS) en signaux numériques (DS) par le convertisseur analogique-numérique (4) ;
- le calcul de quantités électriques (EQ) des réseaux électriques (G) à partir des signaux numériques (DS) par une unité de calcul (5), où l'unité de calcul (5) sélectionne un algorithme approprié selon des exigences spécifiques de zones d'application différentes incluant l'utilisation d'une méthode des moindres carrés pondérés adaptative pour calculer les quantités électriques (EQ) ;
- la réception d'un signal d'horloge (CS) en provenance du module de synchronisation de temps (7) par le convertisseur analogique-numérique (4) pour synchroniser l'échantillonnage de signal ;
- la fourniture d'informations de temps externe (ET) par un module de synchronisation de temps (7) ;
- la synchronisation des quantités électriques avec référence de temps (EQ) avec les informations de temps externe (ET) obtenues à partir du module de synchronisation de temps (7) par l'unité de calcul (5) pour fournir des quantités électriques synchronisées (SEQ) ; et
- la transmission des quantités électriques synchronisées (SEQ) via un module de communication (6) de l'appareil de mesure (1) à un point de collecte de données externe (8).

11. Procédé selon la revendication 10, **caractérisé en ce que** le procédé comprend l'étape supplémentaire de :

- traitement de signaux numériques (DS) provenant d'autres systèmes d'acquisition de données (10) reçus par un module de communication (6) de l'appareil de mesure (1) en plus ou en variante aux signaux analogiques (AS) convertis fournis par l'unité de détection (2).

12. Procédé selon l'une des revendications 10 à 11, **caractérisé en ce que** le procédé comprend l'étape supplémentaire :

- d'obtention des informations de temps externe (ET) à partir de signaux (NS) provenant d'un système de navigation par satellite ou d'un protocole de temps de précision (PTP).

FIG.1

FIG.2

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 20060247874 A

- US 20090099798 A1

### Non-patent literature cited in the description

- Trade-Offs in PMU Deployment for State Estimation in Active Distribution Grids. **JUNQI LIU ; JUNJIE TANG ; PONCI, F. ; MONTI, A. ; MUSCAS, C. ; PEGORARO, P.A.** IEEE Transactions on. Smart Grid, June 2012, vol. 3, 915-924
- **A.G. PHADKE ; J.S. THORP.** Synchronized Phasor Measurements and Their Applications. Springer Science, 2008

- **PAOLONE M ; BORGHETTI A ; NUCCI CA.** A synchrophasor estimation algorithm for the monitoring of active distribution networks in steady state and transient conditions. *17th Power Systems Computation Conference (PSCC'11),* August 2011